(19) **Europäisches Patentamt / European Patent Office / Office européen des brevets**

(11) **EP 2 427 967 B1**

(12) **FASCICULE DE BREVET EUROPEEN**

(45) Date de publication et mention
de la délivrance du brevet:
**03.04.2013 Bulletin 2013/14**

(51) Int Cl.:
**H03M 13/11** *(2006.01)*

(21) Numéro de dépôt: **10727099.3**

(22) Date de dépôt: **05.05.2010**

(86) Numéro de dépôt international:
**PCT/FR2010/050856**

(87) Numéro de publication internationale:
**WO 2010/128248 (11.11.2010 Gazette 2010/45)**

(54) **PROCEDE DE COMMANDE D'UN NOEUD DE PARITE ELEMENTAIRE D' UN DECODEUR DE CODES LDPC NON BINAIRES, ET PROCESSEUR D'UN NOEUD DE PARITE ELEMENTAIRE CORRESPONDANT**

METHODE FÜR DIE STEUERUNG EINES ELEMENTAREN PARITÄTSKNOTEN EINES NICHTBINÄREN LDPC DECODERS UND DER ENTSPRECHENDE ELEMENTARE PARITÄTSKNOTENPROCESSOR

METHOD FOR PROCESSING UN ELEMENTARY PARITY NODE OF A NON-BINARY LDPC DECODER AND THE CORRESPONDING ELEMENTARY PARITY NODE PROCESSOR

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **05.05.2009 FR 0952988**

(43) Date de publication de la demande:
**14.03.2012 Bulletin 2012/11**

(73) Titulaires:
- **Université de Bretagne Sud**
  **56321 Lorient Cedex (FR)**
- **Centre National de la Recherche Scientifique CNRS**
  **75794 Paris Cedex 16 (FR)**

(72) Inventeurs:
- **BOUTILLON, Emmanuel**
  **F-56100 Lorient (FR)**
- **CONDE-CANENCIA, Laura**
  **F-56100 Lorient (FR)**

(74) Mandataire: **Hays, Bertrand**
**Novagraaf Technologies**
**12 Place des Halles Saint Louis**
**56100 Lorient (FR)**

(56) Documents cités:

- **VOICILA A. ET AL.: "Low-Complexity, low-memory EMS algorithm for non-binary LDPC codes" PROC., IEEE INTERNATIONAL CONFERENCE ON COMMUNICATION, ICC 2007, IEEE, PI, 1 juin 2007 (2007-06-01), pages 671-676, XP031125748 ISBN: 978-1-4244-0353-0**
- **VOICILA A. ET AL: "Architecture of a low-complexity non-binary LDPC decoder for high order fields" IEEE, INTERNAT. SYMPOSIUM ON COMMUNICATIONS AND INFORMATION TECHNOLOGIES, ISCIT '07, 1 octobre 2007 (2007-10-01), pages 1201-1206, XP031166645 ISBN: 978-1-4244-0976-1**
- **DECLERCQ D. ET AL: "Decoding algorithms for nonbinary LDPC codes over GF(q)" IEEE TRANSACTIONS ON COMMUNICATIONS, IEEE SERVICE CENTER, PISCATAWAY, NJ, US, vol. 55, no. 4, 1 avril 2007 (2007-04-01), pages 633-643, XP011177031 ISSN: 0090-6778 cité dans la demande**
- **BARNAULT L ET AL: "Fast decoding algorithm for LDPC over GF(2^q)" INFORMATION THEORY WORKSHOP, 2003. PROCEEDINGS. 2003 IEEE 31 MARCH - 4 APRIL 2003, PISCATAWAY, NJ, USA, IEEE, 31 mars 2003 (2003-03-31), pages 70-73, XP010647845 ISBN: 978-0-7803-7799-8**
- **SONG H. ET AL: "Reduced-complexity decoding of Q-ary LDPC codes for magnetic recording" IEEE TRANSACTIONS ON MAGNETICS, IEEE SERVICE CENTER, NEW YORK, NY, US, vol. 39, no. 2, 1 mars 2003 (2003-03-01), XP011075938 ISSN: 0018-9464**

**Description**

La présente invention concerne un procédé de commande d'un noeud de parité élémentaire d'un décodeur de codes LDPC non binaires ou d'un décodeur de codes utilisant au moins une contrainte de parité non binaire, et le noeud de parité élémentaire correspondant.

Les codes LDPC (Low Density Parity Check en langue anglaise) sont des codes correcteurs d'erreur connus pour approcher la limite théorique de transmission de Shannon. En raison de leurs performances en termes d'immunité au bruit, les codes LDPC, et notamment les codes LDPC non binaires, trouvent une application dans le domaine de la transmission et du stockage de données numériques.

Les codes LDPC non binaires sont construits dans un corps de Galois non binaire d'ordre q, notés classiquement GF(q). Un code LDPC dans GF(q) est défini par une matrice de parité H creuse de dimension M x N dont les éléments appartiennent à GF(q), N étant le nombre d'éléments de GF(q) dans le mot de code et M étant le nombre de contraintes de parité. Pour un corps de Galois GF(4) composé de 4 éléments $\{0, \alpha^0, \alpha^1, \alpha^2\}$, la matrice de parité pour N=6 et M=3 est par exemple la suivante:

$$H = \begin{pmatrix} 0 & \alpha^0 & \alpha^0 & 0 & \alpha^2 & 0 \\ \alpha^1 & 0 & 0 & \alpha^0 & 0 & \alpha^2 \\ \alpha^0 & 0 & \alpha^2 & 0 & 0 & \alpha^1 \end{pmatrix}$$

Cette matrice peut également être représentée par un graphe bipartite (graphe de Tanner) ayant N noeuds de variable recevant les symboles du mot de code et M noeuds de parité. Chaque colonne de la matrice de parité est associée à un noeud de variable et chaque ligne de la matrice est associée à un noeud de parité. Dans le cas d'un code LDPC régulier, chaque noeud de parité est connecté, par l'intermédiaire de $d_c$ branches, à un même nombre $d_c$ de noeuds de variable. Réciproquement, chaque noeud de variable est connecté, par l'intermédiaire de $d_v$ branches, à un même nombre $d_v$ de noeuds de parité. Dans le cas d'un code LDPC irrégulier, le nombre $d_c$ ou $d_v$ de branches varie selon le noeud de variable ou noeud de parité.

Le décodage de ces codes LDPC est itératif et consiste à échanger via ces branches des messages, chaque noeud de variable ou de parité traitant les messages reçus et délivrant, après traitement, d'autres messages à destination, selon le cas, des noeuds de parité ou des noeuds de variable auxquels ils sont connectés par des branches. Les messages échangés représentent des densités de probabilité des symboles du code et se présentent donc sous la forme de vecteurs de taille q. Un tel décodage est décrit dans le document intitulé « Decoding Algorithms for Nonbinary LDPC Codes Over GF(q) » de D.Declercq et M.Fossorier, Communications IEEE Transactions on Volume 55, Issue 4, April 2007, Pagess633 - 643.

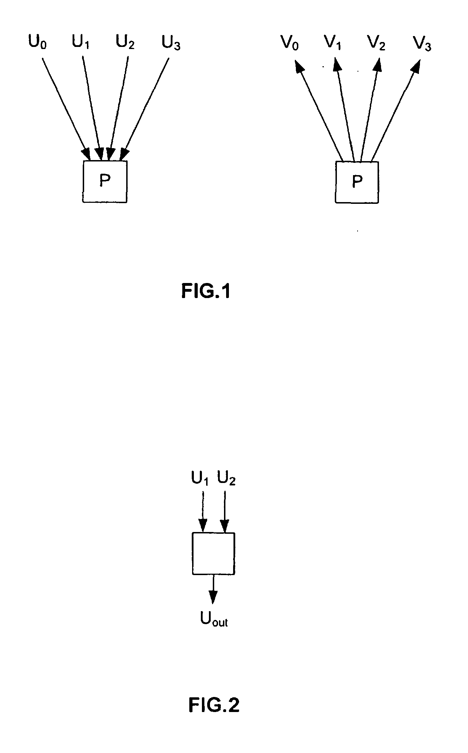

L'invention concerne plus particulièrement le procédé de commande des noeuds de parité du décodeur. En référence à la figure 1, chaque noeud de parité P reçoit une pluralité de messages entrants $U_i$ et délivre des messages sortants $V_j$, avec $i \in [0...dv - 1]$, tels que $\quad V_j = \bigoplus_{j \neq i} U_i \quad$ où $\oplus$ est l'opérateur sur les densités de probabilité associé à l"addition du corps de Galois GF(q).

Dans l'exemple de la figure 1, le noeud de parité reçoit $d_c$=4 messages entrants $U_0, U_1, U_2, U_3$ et délivre 4 messages sortants $V_0, V_1, V_2, V_3$ tels que:

$$\begin{cases} V_0 = U_1 \oplus U_2 \oplus U_3 \\ V_1 = U_0 \oplus U_2 \oplus U_3 \\ V_2 = U_0 \oplus U_1 \oplus U_3 \\ V_3 = U_0 \oplus U_1 \oplus U_2 \end{cases}$$

On peut décomposer chacun de ces calculs en calculs élémentaires exécutés par des noeuds de parité élémentaires ayant deux entrées et une sortie.

Par exemple, pour le calcul de $V_0$, un premier noeud de parité élémentaire effectue l'opération $U_1 \oplus U_2 = U_{int}$ puis un second noeud de parité élémentaire effectue l'opération $U_{int} \oplus U_3$. A noter que le résultat intermédiaire $U_{int}$ à

la sortie du premier noeud de parité élémentaire est également utilisé pour calculer $V_3$.

Ainsi, on peut décomposer chaque noeud de parité en une pluralité de noeuds de parité élémentaires recevant chacun deux messages entrants, par exemple $U_1$ et $U_2$, et délivrant un message sortant $U_{out}=U_{int}$. Un tel noeud est représenté schématiquement à la figure 2. Chaque message entrant ou sortant est un vecteur de taille q associant une densité de probabilité à chaque élément du corps de Galois. Dans la suite de la description, on considère à titre d'exemple un corps de Galois GF(4) composé des éléments {0, $\alpha^0$, $\alpha^1$, $\alpha^2$} dont les lois d'addition et de multiplication sont définies par les tableaux suivants:

| $\oplus$ | 0 | $\alpha^0$ | $\alpha^1$ | $\alpha^2$ |
|---|---|---|---|---|
| 0 | 0 | $\alpha^0$ | $\alpha^1$ | $\alpha^2$ |
| $\alpha^0$ | $\alpha^0$ | 0 | $\alpha^2$ | $\alpha^1$ |
| $\alpha^1$ | $\alpha^1$ | $\alpha^2$ | 0 | $\alpha^0$ |
| $\alpha^2$ | $\alpha^2$ | $\alpha^1$ | $\alpha^0$ | 0 |

| $\otimes$ | 0 | $\alpha^0$ | $\alpha^1$ | $\alpha^2$ |
|---|---|---|---|---|
| 0 | 0 | 0 | 0 | 0 |
| $\alpha^0$ | 0 | $\alpha^0$ | $\alpha^1$ | $\alpha^2$ |
| $\alpha^1$ | 0 | $\alpha^1$ | $\alpha^2$ | $\alpha^0$ |
| $\alpha^2$ | 0 | $\alpha^2$ | $\alpha^0$ | $\alpha^1$ |

Le messages entrants sont par exemple $U_1=(a_0,a_1,a_2,a_3)$ et $U_2=(b_0,b_1,b_2,b_3)$ où $a_i$ est la densité de probabilité associé à l'élément $\alpha^i$ dans le message $U_1$ et où bi est la densité de probabilité associé à l'élément $\alpha^1$ dans le message $U_2$, $i \in [0...3]$, avec $a_0+a_1+a_2+a_3=1$ et $b_0+b_1+b_2+b_3=1$.

Compte tenu de la loi d'addition définie ci-dessus pour le corps de Galois GF(4), le message sortant $U_{out}$ est égal à $U_{out} = (c_0,c_1,c_2,c_3)$ où

$$c_0 = a_0 \cdot b_0 + a_1 \cdot b_1 + a_2 \cdot b_2 + a_3 \cdot b_3$$

$$c_1 = a_0 \cdot b_1 + a_1 \cdot b_0 + a_3 \cdot b_2 + a_2 \cdot b_3$$

$$c_2 = a_0 \cdot b_2 + a_1 \cdot b_3 + a_2 \cdot b_0 + a_3 \cdot b_1$$

$$c_3 = a_0 \cdot b_3 + a_1 \cdot b_2 + a_2 \cdot b_1 + a_3 \cdot b_0$$

Des densités de probabilité sont ainsi échangées entre les noeuds de parité et les noeuds de variable, et inversement, jusqu'au décodage complet du mot de code. On parle alors d'algorithme de propagation de croyances ou "belief propagation" en langue anglaise.

La mise en oeuvre d'un tel algorithme est relativement complexe et nécessite l'exécution de $q^2$ multiplications dans chaque noeud de parité élémentaire pour des éléments appartenant à GF(q).

Pour réduire cette complexité, il est connu de travailler dans le domaine logarithmique pour transformer les multiplications en additions. Les données échangées entre noeuds sont des logarithmes de rapport de vraisemblance ou LLR (pour Log Likelihood Ratio en langue anglaise).

Une autre solution connue pour réduire cette complexité consiste à ne tenir compte, pour le calcul des densités de probabilité du message sortant, que des $n_m$ plus grandes densités de probabilité dans les messages entrants, $n_m<q$. Cet algorithme appelé EMS (pour Extended Min-Sum en langue anglaise) est décrit de manière détaillée dans le document intitulé "Algorithmes simplifiés pour le décodage de codes LDPC non binaires" de A.Voicila, D.Declercq, M.Fossorier et F.Verdier, GRETSI, Louvain-la-Neuve, Belgique, Septembre 2005. Cette solution peut être combinée avec la solution précédente de sorte que les données échangées soient des logarithmes de rapport de vraisemblance.

Selon cet algorithme, les messages entrants $U_1$ et $U_2$ sont filtrés et triés avant d'être traités par le noeud de parité élémentaire. Les messages fournis au noeud de parité élémentaire sont alors des listes ne comportant que $n_m$ valeurs de densité de probabilité ou de LLR triées dans l'ordre décroissant, chaque valeur de densité de probabilité ou de LLR étant associée à un élément du corps de Galois GF(q). Le nombre de valeurs de densité de probabilité ou de LLR prises en compte par le noeud de parité élémentaire étant réduit ($n_m<q$), la complexité de cet algorithme est réduite mais reste toutefois élevée.

En outre, le document intitulé "Low-complexity, low-memory EMS algorithm for non-binary LDPC codes" de A.Voicila et al. ICC 2007, Juin 2007, divulgue une implémentation efficace d'un décodeur EMS.

Le but de la présente invention est de proposer un algorithme permettant de réduire encore plus le nombre de calculs dans les noeuds de parité élémentaires.

A cet effet, la présente invention propose un procédé de commande d'un noeud de parité élémentaire d'un décodeur de codes LDPC non binaires ou d'un décodeur de codes utilisant au moins une contrainte de parité non binaire, ledit noeud de parité élémentaire recevant des première et secondes listes, dites première et seconde listes d'entrée, de $n_m$ éléments triés dans un ordre défini parmi un ordre décroissant et un ordre croissant, , $n_m$ étant supérieur à 1, et délivrant une liste, dite liste de sortie, de $n_m'$ éléments triés dans ledit ordre défini, $n_m'$ étant supérieur à 1, chaque élément de la liste de sortie étant le résultat d'une opération de calcul $\varphi$ entre un élément de la première liste d'entrée et un élément de la deuxième liste d'entrée, ladite opération de calcul $\varphi$ étant telle que si a≥b et c≥d alors $\varphi(a, c) \geq \varphi(b, d)$, ledit procédé étant remarquable en ce qu'il comprend les étapes suivantes :

a) sélectionner les p premiers éléments de la première liste d'entrée et le premier élément de la deuxième liste d'entrée, p étant un nombre prédéterminé inférieur à $n_m$,

b) effectuer des opérations de calcul $\varphi$ entre les éléments sélectionnés de la première liste d'entrée et l'élément sélectionné de la seconde liste d'entrée de manière à générer une liste de p éléments candidats pour la liste de sortie,

c) déterminer, parmi les p éléments candidats, l'élément candidat ayant la valeur la plus élevée si l'ordre défini est l'ordre décroissant ou l'élément candidat ayant la valeur la plus faible si l'ordre défini est l'ordre croissant, et l'introduire dans la liste de sortie, l'élément candidat introduit dans la liste de sortie étant le résultat de l'opération de calcul $\varphi$ entre un élément d'ordre i de la première liste d'entrée et un élément d'ordre j de la deuxième liste d'entrée, i et j étant compris entre 1 et $n_m$,

d) sélectionner, selon un critère prédéterminé, l'élément d'ordre i de la première liste d'entrée et l'élément d'ordre j+1 de la deuxième liste d'entrée ou l'élément d'ordre i+1 de la première liste d'entrée et l'élément d'ordre j de la deuxième liste d'entrée,

e) effectuer une opération de calcul $\varphi$ entre les éléments sélectionnés à l'étape précédente de manière à générer un nouvel élément candidat, et remplacer, dans la liste des p éléments candidats, le dernier élément candidat introduit dans la liste de sortie par ledit nouvel élément candidat,

f) déterminer, parmi les p éléments candidats, l'élément candidat ayant la valeur la plus élevée si l'ordre défini est l'ordre décroissant ou l'élément candidat ayant la valeur la plus faible si l'ordre défini est l'ordre croissant, et l'introduire dans la liste de sortie dans l'ordre de détermination, l'élément candidat introduit dans la liste de sortie étant le résultat de l'opération de calcul entre un élément d'ordre i de la première liste d'entrée et un élément d'ordre j de la deuxième liste d'entrée, et

g) réitérer les étapes d) à f) jusqu'à ce que la liste de sortie comporte $n_m'$ éléments.

Ainsi, selon l'invention, la liste des éléments candidats pour chaque élément de la liste de sortie ne comporte que $p<n_m$ éléments, ce qui permet de réduire le nombre de calculs et de comparaisons du procédé.

Selon un mode de réalisation avantageux, le nombre p est pris égal à $\left\lceil \dfrac{-1 + \sqrt{-7 + 8n_m'}}{2} \right\rceil$ qui

représente le nombre de candidats possibles pour chaque élément de la liste de sortie et où $\lceil x \rceil$ représente le plus petit nombre entier supérieur ou égal au nombre réel x.

Selon un premier critère prédéterminé, la sélection effectuée à l'étape d) dépend uniquement de l'ordre i de l'élément de la première liste d'entrée et/ou de l'ordre j de l'élément de la deuxième liste d'entrée associé à l'élément candidat introduit dans la liste de sortie.

Selon un deuxième critère prédéterminé, la sélection effectuée à l'étape d) dépend non seulement de l'ordre i de l'élément de la première liste d'entrée et/ou de l'ordre j de l'élément de la deuxième liste d'entrée associé à l'élément candidat introduit dans la liste de sortie mais également d'un drapeau représentatif de la sélection effectuée à l'étape d) précédente.

Dans le cadre du décodage de codes LDPC non binaires, les éléments des première et seconde listes d'entrée sont des densités de probabilité ou des valeurs LLR associées chacune à un symbole dans un corps de Galois. Dans ce cadre et selon un mode de réalisation particulier, l'étape f) comprend en outre, après détermination de l'élément candidat ayant la valeur la plus faible ou la plus élevée, une étape de détermination du symbole associé audit élément candidat déterminé, ledit élément candidat déterminé étant introduit dans la liste de sortie si et seulement si le symbole associé audit élément candidat déterminé n'est pas associé à un élément candidat déjà présent dans liste de sortie c'est-à-dire à l'élément candidat introduit dans la liste de sortie à l'étape c) ou à un élément candidat introduit dans la liste de sortie à une étape f) précédente.

L'invention concerne également un noeud de parité élémentaire pour décodeur de codes LDPC non binaires ou décodeur de codes utilisant au moins une contrainte de parité non binaire, comprenant:

- des première et seconde entrées pour recevoir des première et seconde listes, dites première et seconde listes d'entrée, de $n_m$ éléments triés dans un ordre défini parmi un ordre décroissant et un ordre croissant, $n_m$ étant supérieur à 1,
- une sortie pour délivrer une liste, dite liste de sortie, de $n_m'$ éléments triés dans l'ordre défini, $n_m'$ étant supérieur ou égal à 1, chaque élément de la liste de sortie étant le résultat d'une opération de calcul $\varphi$ entre un élément de la première liste d'entrée et un élément de la deuxième liste d'entrée, ladite opération de calcul $\varphi$ étant telle que si $a \geq b$ et $c \geq d$ alors $\varphi(a, c) \geq \varphi(b, d)$,
- des premiers moyens de stockage pour stocker les éléments desdites première et secondes listes d'entrée,
- un circuit de calcul pour effectuer des opérations de calcul $\varphi$ entre des éléments de la première liste d'entrée et des éléments de la seconde liste d'entrée stockés dans lesdits premiers moyens de stockage de manière à générer, à chaque opération, un élément candidat,
- des seconds moyens de stockage pour stocker les éléments candidats calculés par lesdits moyens de calcul,
- un circuit de comparaison pour déterminer, parmi les éléments candidats stockés dans les seconds moyens de stockage, l'élément candidat ayant la valeur la plus élevée si l'ordre défini est l'ordre décroissant ou l'élément candidat ayant la valeur la plus faible si l'ordre défini est l'ordre croissant, et fournir ledit élément candidat déterminé à ladite sortie, l'élément candidat fourni à la sortie étant le résultat de l'opération de calcul $\varphi$ entre un élément d'ordre i de la première liste d'entrée et un élément d'ordre j de la deuxième liste d'entrée, i et j étant compris entre 1 et $n_m$, et
- un circuit de commande pour contrôler la sélection des éléments stockés dans lesdits premiers moyens de stockage à fournir au circuit de calcul et le stockage des éléments candidats calculés dans les seconds moyens de stockage,

caractérisé en ce que les seconds moyens de stockage comprennent p registres pour stocker p éléments candidats, p étant un nombre prédéterminé inférieur à $n_m$,
en ce que ledit circuit de comparaison est apte à fournir au circuit de commande une information représentative des ordres i et j associés audit élément candidat fourni à la sortie, et le circuit de commande est apte à commander lesdits premiers moyens de stockage et lesdits seconds moyens de stockage pour la mise en oeuvre du procédé de commande défini précédemment.

L'invention sera mieux comprise, et d'autres buts, détails, caractéristiques et avantages apparaîtront plus clairement au cours de la description explicative détaillée qui va suivre de modes de réalisation de l'invention, en référence aux figures annexées, parmi lesquelles :

- la figure 1, déjà décrite, représente schématiquement un noeud de parité recevant quatre messages entrants (partie gauche de la figure) et délivrant quatre messages sortants (partie droite de la figure) ; et,
- la figure 2, déjà décrite, représente schématiquement un noeud de parité élémentaire recevant deux messages entrants et délivrant un message sortant, et
- la figure 3 représente la structure d'un noeud de parité élémentaire apte à mettre en oeuvre le procédé de l'invention.

Dans la suite de la description, on considère un noeud de parité élémentaire recevant en entrée des listes de $n_m$ éléments triées dans l'ordre décroissant et délivrant en sortie une liste de $n_m$ éléments également triée dans l'ordre décroissant. On considère également que ce noeud de parité élémentaire travaille dans le domaine logarithmique, les données échangées entre noeuds étant alors des valeurs de LLR.

Plus particulièrement, l'invention sera décrite ci-après en référence à un noeud de parité élémentaire recevant, en tant que messages entrants, deux listes d'entrée $U_1$ et $U_2$ de $n_m$ valeurs de LLR triées dans l'ordre décroissant et délivrant, en tant que message sortant, une liste de sortie $U_{out}$ de $n_m'$ valeurs de LLR, avec $n_m' > 1$.

Les éléments des listes $U_1$ et $U_2$ sont notés respectivement $U_1(i)$ et $U_2(j)$, avec $i = 1...n_m$ et $j = 1...n_m$. Ces listes étant triées dans l'ordre décroissant, on a :

$$\forall\ i \in [1, n_m - 1]\ ,\ U_1(i) \geq U_1(i+1),$$

et

$$\forall\ j \in [1, n_m - 1]\ ,\ U_2(j) \geq U_2(j+1).$$

La liste de sortie $U_{out}$ comprend $n_m'$ valeurs correspondant aux $n_m'$ valeurs de LLR les plus élevées de l'ensemble $U_\varphi = U_\Sigma = \{(i, j) \in [1, n_m]^2, U_1(i) + U_2(j)\}$ triées dans l'ordre décroissant. L'ensemble $U_\Sigma$ est obtenu à partir de la matrice $T_\Sigma$ de taille $n_m \times n_m$ ou chaque élément $T_\Sigma(i,j) = U_1(i) + U_2(J)$ avec $i = 1...n_m$ et $j = 1...n_m$.

Pour bien comprendre le procédé de l'invention et ses avantages, nous allons tout d'abord décrire, à travers un exemple, le processus de génération de la liste de sortie $U_{out}$ selon l'algorithme EMS de l'art antérieur. Chacune des listes d'entrée $U_1$ et $U_2$ comporte un nombre $n_m$ restreint d'éléments correspondant aux $n_m$ plus grandes valeurs de LLR contenues dans chacun des messages entrants du noeud de parité élémentaire.

Pour cet exemple, on considère deux listes d'entrée $U_1$={90, 87, 60, 55, 54, 30, 29, 23, 18, 17} et $U_2$={90, 81, 73, 60, 59, 49, 31, 30, 29, 28}. Chacune de ces listes d'entrée comporte $n_m$=10 éléments. On cherche à générer une liste de sortie $U_{out}$ comportant $n_m$'=15 éléments.

La matrice $T_\Sigma$ est alors définie par le tableau suivant:

Tableau 1

|  |  | $U_2(1)$ 90 | $U_2(2)$ 81 | $U_2(3)$ 73 | $U_2(4)$ 60 | $U_2(5)$ 59 | $U_2(6)$ 49 | $U_2(7)$ 31 | $U_2(8)$ 30 | $U_2(9)$ 29 | $U_2(10)$ 28 |
|---|---|---|---|---|---|---|---|---|---|---|---|
| $U_1(1)$ | 90 | 180 | 171 | 163 | 150 | 149 | 139 | 121 | 120 | 119 | 118 |
| $U_1(2)$ | 87 | 177 | 168 | 160 | 147 | 146 | 136 | 118 | 117 | 116 | 115 |
| $U_1(3)$ | 60 | 150 | 141 | 133 | 120 | 119 | 109 | 91 | 90 | 89 | 88 |
| $U_1(4)$ | 55 | 145 | 136 | 128 | 115 | 114 | 104 | 86 | 85 | 84 | 83 |
| $U_1(5)$ | 54 | 144 | 135 | 127 | 114 | 113 | 103 | 85 | 84 | 83 | 82 |
| $U_1(6)$ | 30 | 120 | 111 | 103 | 90 | 89 | 79 | 61 | 60 | 59 | 58 |
| $U_1(7)$ | 29 | 119 | 110 | 102 | 89 | 88 | 78 | 60 | 59 | 58 | 57 |
| $U_1(8)$ | 23 | 113 | 104 | 96 | 83 | 82 | 72 | 54 | 53 | 52 | 51 |
| $U_1(9)$ | 18 | 108 | 99 | 91 | 78 | 77 | 67 | 49 | 48 | 47 | 46 |
| $U_1(10)$ | 17 | 107 | 98 | 90 | 77 | 76 | 66 | 48 | 47 | 46 | 45 |

Pour générer la liste de sortie $U_{out}$, on commande le noeud de parité élémentaire de la façon suivante. On sélectionne tout d'abord les $n_m$ éléments de la liste $U_1$ et le premier élément de liste $U_2$ et on effectue les $n_m$ additions correspondant à la première colonne du tableau. On obtient ainsi une liste de $n_m$ éléments candidats pour le premier élément de la liste $U_{out}$. On extrait de la liste des candidats l'élément ayant la valeur la plus élevée en comparant les éléments candidats entre eux ($n_m$ comparaisons). Cet élément, qui est $T_\Sigma(1,1)$, constitue le premier élément de la liste de sortie $U_{out}$. On remplace ensuite, dans liste des candidats, l'élément candidat extrait $T_\Sigma(1,1)$ par l'élément $T_\Sigma(1,2)$ qui est l'élément de la ligne i=1 ayant la valeur la plus élevée parmi les éléments non encore extraits de cette ligne, l'élément $T_\Sigma(1,2)$ ayant été préalablement obtenu en sélectionnant les éléments $U_1(1)$ et $U_2(2)$ et en les additionnant. On extrait ensuite de cette nouvelle liste de candidats l'élément ayant la valeur la plus élevée. L'élément extrait constitue le deuxième élément de la liste $U_{out}$. On opère ainsi jusqu'à obtenir une liste de sortie comportant $n_m$' valeurs. A chaque itération, on remplace l'élément extrait $T_\Sigma(i,j)$ par l'élément $T_\Sigma(i,j+1)$ qui est l'élément de la ligne i ayant la valeur la plus élevée parmi les éléments non encore extraits de cette ligne. Au final, on obtient la liste de sortie $U_{out}$=(180, 177, 171, 168, 163, 160, 150, 150, 149, 147, 146, 145, 144, 141, 136}.

Selon cet algorithme EMS, le noeud de parité élémentaire effectue, pour la première itération (génération du premier élément de la liste $U_{out}$), $n_m$ additions et $n_m$ comparaisons et, pour chacune des itérations suivantes (génération des $n_m$' - 1 derniers éléments de la liste $U_{out}$), 1 addition et $n_m$ comparaisons. La génération de la liste $U_{out}$ complète ($n_m$' éléments) requiert donc l'exécution de $n_m$+$n_m$'-1 additions et $n_m*n_m$' comparaisons.

Le procédé de l'invention vise à réduire ce nombre d'opérations. Le procédé de l'invention va maintenant être explicité.

Etant donné que les listes $U_1$ et $U_2$ sont triées dans l'ordre décroissant, on a les propriétés suivantes:

$$\forall j \in [1, n_m] \text{ et } i > i', \text{ alors } T_\Sigma(i, j) > T_\Sigma(i', j) \qquad (1)$$

$$\forall i \in [1, n_m] \text{ et } j > j', \text{ alors } T_\Sigma(i, j) > T_\Sigma(i, j') \qquad (2)$$

La conséquence de ces deux propriétés est que la valeur la plus élevée de la matrice $T_\Sigma$ est $T_\Sigma(1,1)$. La valeur la plus élevée suivante de la matrice est soit $T_\Sigma(2,1)$, soit $T_\Sigma(1,2)$. Seuls deux candidats sont donc possibles pour le deuxième élément de la liste $U_{out}$.

De manière plus générale, le nombre de candidats possibles pour le $n^{ième}$ élément de la liste de sortie $U_{out}$ peut être déterminé par la fonction

$$\psi(n) = \left\lceil \frac{-1 + \sqrt{-7 + 8n}}{2} \right\rceil \qquad (3)$$

où $\lceil y \rceil$ est la fonction définissant le plus petit nombre entier naturel supérieur ou égal au nombre réel y.

Cette fonction est déduite des tableaux suivants représentant la matrice $T_\Sigma$. Dans ces tableaux, une croix x représente un élément candidat préalablement sélectionné dans la liste $U_{out}$ et un rond O représente un élément candidat possible pour être le prochain élément de la liste $U_{out}$. Si on prend $n_m=5$, la matrice $T_\Sigma$ représentée comprend 5 colonnes et 5 lignes. Comme indiqué précédemment, le premier élément de la liste de sortie $U_{out}$ est nécessairement l'élément $T_\Sigma(1,1)$. Une croix est donc représentée dans la case correspondante du tableau.

Pour la détermination du deuxième élément de la liste $U_{out}$ (n=2), il y a deux candidats possibles qui sont $T_\Sigma(2,1)$ et $T_\Sigma(1,2)$ comme illustré par le tableau suivant:

Tableau 2

|        | $U_1(1)$ | $U_1(2)$ | $U_1(3)$ | $U_1(4)$ | $U_1(5)$ |
|--------|------|------|------|------|------|
| $U_2(1)$ | X | O |  |  |  |
| $U_2(2)$ | O |  |  |  |  |
| $U_2(3)$ |  |  |  |  |  |
| $U_2(4)$ |  |  |  |  |  |
| $U_2(5)$ |  |  |  |  |  |

Pour la détermination du troisième élément (n=3) de la liste $U_{out}$, on a les tableaux suivants: le tableau 3 représente le cas où l'élément $T_\Sigma(1,2)$ est le deuxième élément de la liste $U_{out}$ et le tableau 4 représente l'autre cas (cas où l'élément $T_\Sigma(2,1)$ est le deuxième élément de la liste $U_{out}$). Dans les deux cas, il y a deux candidats possibles O pour extraire le troisième élément.

Tableau 3

| X | X | O |  |  |
|---|---|---|---|---|
| O |  |  |  |  |
|  |  |  |  |  |

Tableau 4

| X | O |  |  |  |
|---|---|---|---|---|
| X |  |  |  |  |
| O |  |  |  |  |

Pour la détermination du quatrième élément (n=4) de la liste $U_{out}$, on a les tableaux suivants:

Tableau 5

| X | X | X | O |  |
|---|---|---|---|---|
| O |  |  |  |  |
|  |  |  |  |  |

Tableau 6

| X | X | O |  |  |
|---|---|---|---|---|
| X | O |  |  |  |
| O |  |  |  |  |

Tableau 7

| X | O |  |  |  |
|---|---|---|---|---|
| X |  |  |  |  |
| X |  |  |  |  |
| O |  |  |  |  |

Le tableau 6 illustre le cas le plus défavorable (cas où le nombre de candidats possibles est le plus élevé) avec 3 candidats possibles.

Sinon, les cas les plus défavorables où le nombre de candidats possibles est supérieur à 3 sont obtenus pour la détermination du septième élément (n=7) et du onzième élément (n=11) de la liste $U_{out}$. Ces cas sont illustrés par les tableaux suivants:

Tableau 8

| X | X | X | O |  |
|---|---|---|---|---|
| X | X | O |  |  |
| X | O |  |  |  |
| O |  |  |  |  |

Tableau 9

| X | X | X | X | O |
|---|---|---|---|---|
| X | X | X | O |  |
| X | X | O |  |  |
| X | O |  |  |  |
| O |  |  |  |  |

De ces tableaux, on peut déduire que, dans le cas le plus défavorable (nombre maximum de candidats possibles), il y a m+1 candidats possibles pour la détermination du $n^{\text{ième}}$ élément de la liste $U_{out}$, avec

$$n = \frac{m(m + 1)}{2} + 1.$$

On peut alors en déduire la fonction $\psi(n) = \left\lceil \frac{-1 + \sqrt{-7 + 8n}}{2} \right\rceil$ qui donne le nombre maximum de candidats possibles pour la détermination du $n^{\text{ième}}$ élément de la liste $U_{out}$.

La fonction $\psi$ étant croissante, la valeur $\psi(n)$ est maximale pour la dernière itération ($n=n_m$') du processus de génération de la liste $U_{out}$. Aussi, quel que soit l'élément de la liste $U_{out}$ à déterminer, il y a au maximum

$$\psi(n_m') = \left\lceil \frac{-1 + \sqrt{-7 + 8n_m'}}{2} \right\rceil$$ candidats possibles.

Selon l'invention, on propose d'utiliser ce résultat pour réduire le nombre d'opérations (additions et comparaisons) effectuées par le noeud de parité élémentaire. Plus précisément, étant donné que le nombre de candidats possibles pour générer la liste $U_{out}$ est au maximum de $p = \psi(n_m')$, on propose selon l'invention de ne sélectionner qu'un nombre réduit, p, de candidats possibles à chaque itération du processus de génération de la liste de sortie $U_{out}$, ces éléments candidats possibles étant alors sélectionnés de manière appropriée.

On va illustrer comme précédemment le procédé de l'invention à l'aide de tableaux représentant la matrice $T_\Sigma$. Dans ces tableaux, on considère que $n_m = 5$ et $n_m' = 10$. Comme précédemment, une croix x représente un élément candidat préalablement sélectionné dans la liste $U_{out}$ et un rond O représente un candidat possible pour l'itération en cours. On a $\psi(n_m') = 4$, soit une liste de 4 candidats possibles à chaque itération. A la première itération (n=1), les 4 candidats possibles sont les 4 premiers éléments de la première colonne de la matrice $T_\Sigma$, i.e. $T_\Sigma(1,1)$, $T_\Sigma(2,1)$, $T_\Sigma(3,1)$ et $T_\Sigma(4,1)$, comme illustré par le tableau suivant:

Tableau 10

|        | $U_1(1)$ | $U_1(2)$ | $U_1(3)$ | $U_1(4)$ | $U_1(5)$ |
|--------|----------|----------|----------|----------|----------|
| $U_2(1)$ | O |  |  |  |  |
| $U_2(2)$ | O |  |  |  |  |
| $U_2(3)$ | O |  |  |  |  |
| $U_2(4)$ | O |  |  |  |  |
| $U_2(5)$ |  |  |  |  |  |

L'élément sélectionné pour cette première itération (n=1) est $T_\Sigma(1,1)$. Cet élément est extrait de la liste des candidats possibles et est remplacé par $T_\Sigma(1,2)$. D'une manière plus générale, à chaque fois qu'un élément $T_\Sigma(i,j)$ est extrait de la liste des candidats, il est connu de le remplacer par l'élément $T_\Sigma(i,j+1)$.

Pour l'itération suivante (n=2), la liste des candidats est illustrée par le tableau suivant.

Tableau 11

|        | $U_1(1)$ | $U_1(2)$ | $U_1(3)$ | $U_1(9)$ | $U_1(5)$ |
|--------|----------|----------|----------|----------|----------|
| $U_2(1)$ | X | O |  |  |  |
| $U_2(2)$ | O |  |  |  |  |
| $U_2(3)$ | O |  |  |  |  |
| $U_2(4)$ | O |  |  |  |  |
| $U_2(5)$ |  |  |  |  |  |

Le fait d'avoir un nombre restreint de candidats possibles peut poser problème dans certaines situations, par exemple lorsque l'élément $T_\Sigma(\psi(n_m'),1)$ est sélectionné puis extrait comme illustré par le tableau suivant:

Tableau 12

|        | $U_1(1)$ | $U_1(2)$ | $U_1(3)$ | $U_1(4)$ | $U_1(5)$ |
|--------|----------|----------|----------|----------|----------|
| $U_2(1)$ | X | O |  |  |  |
| $U_2(2)$ | X | O |  |  |  |
| $U_2(3)$ | X | O |  |  |  |
| $U_2(4)$ | X | O |  |  |  |
| $U_2(5)$ |  |  |  |  |  |

Si on applique la loi de remplacement décrite ci-avant, l'élément $T_\Sigma(4,1)$ extrait à la quatrième itération (n=4) est remplacé par l'élément $T_\Sigma(4,2)$. Or, $T_\Sigma(4,2)$ n'est pas un "vrai" candidat puisqu'il est nécessairement inférieur à $T_\Sigma(3,2)$ qui est déjà dans la liste des candidats. A contrario, $T_\Sigma(5,1)$ qui est un vrai candidat pour l'itération suivante (n=5) n'est pas dans la liste de candidats.

Aussi, pour éviter ce problème, on propose de modifier la règle de remplacement au moins pour certains éléments de la liste des candidats possibles.

Selon un premier mode de réalisation, on utilise un drapeau D permettant de modifier la sélection de l'élément à introduire dans la liste des candidats. Ce drapeau D présente deux états : "horizontal" et "vertical". Lorsque le drapeau D est "horizontal" et que l'élément extrait de la liste des candidats est $T_\Sigma(i,j)$, alors l'élément $T_\Sigma(i,j)$ est remplacé par l'élément $T_\Sigma(i,j+1)$ dans la liste des candidats. En revanche, lorsque le drapeau D est "vertical" et que l'élément extrait de la liste des candidats est $T_\Sigma(i,j)$, alors l'élément $T_\Sigma(i,j)$ est remplacé par l'élément $T_\Sigma(i+1,j)$ dans la liste des candidats. En début de processus de génération de la liste $U_{out}$, le drapeau est initialisé à l'état "horizontal" et reste dans cet état tant que l'ordre i de l'élément extrait $T_\Sigma(i,j)$ est inférieur à $\psi(n_m')$. Lorsque l'ordre i de l'élément extrait $T_\Sigma(i,j)$ est supérieur ou égal à $p=\psi(n_m')$, le drapeau D change d'état et passe à l'état "vertical". Il reste dans l'état "vertical" tant que l'ordre j de l'élément extrait $T_\Sigma(i,j)$ est inférieur à p. Enfin, lorsque l'ordre j de l'élément extrait $T_\Sigma(i,j)$ est supérieur ou égal à p, le drapeau D repasse à l'état "horizontal". Le drapeau D dépend donc du dernier indice i ou j à devenir supérieur à p.

Si on reprend l'exemple de la matrice $T_\Sigma$ définie dans le tableau 1, on commande le noeud de parité élémentaire de la façon suivante avec $n_m=10$, $n_m'=15$ et p=5.

Au départ, on sélectionne les p=5 premiers éléments de la liste $U_1$ et le premier élément de la liste $U_2$ et on les additionne ensemble de manière à obtenir les 5 éléments suivants: $T_\Sigma(1,1)$, $T_\Sigma(2,1)$, $T_\Sigma(3,1)$, $T_\Sigma(4,1)$ et $T_\Sigma(5,1)$. Ces 5 éléments forment alors la liste de candidats possibles pour le premier élément de la liste de sortie $U_{out}$. On extrait l'élément candidat ayant la valeur la plus élevée, $T_\Sigma(1,1)=180$, pour former le premier élément de la liste de sortie $U_{out}$ et, comme le drapeau D est à l'état "horizontal" et que i=1<p, le drapeau D reste à l'état "horizontal" et on remplace $T_\Sigma(1,1)$ par $T_\Sigma(1,2)$ dans la liste des candidats possibles.

Pour l'itération suivante (n=2), la liste des candidats possibles comprend les éléments $T_\Sigma(1,2)$, $T_\Sigma(2,1)$, $T_\Sigma(3,1)$, $T_\Sigma(4,1)$ et $T_\Sigma(5,1)$. On extrait l'élément candidat ayant la valeur la plus élevée, $T_\Sigma(2,1)=177$, pour constituer le deuxième élément de la liste de sortie $U_{out}$ et, comme le drapeau D est à l'état "horizontal" et que i=2<p, le drapeau D reste à l'état "horizontal" et on remplace $T_\Sigma(2,1)$ par $T_\Sigma(2,2)$ dans la liste des candidats possibles.

Les itérations n=3 jusqu'à n=12 sont identiques aux itérations n=1 et n=2. Les itérations n=1 à n=12 sont illustrées par les 12 tableaux suivants, chaque tableau étant associé à une itération. La deuxième colonne de chacun des tableaux représente la liste des éléments candidats $T_\Sigma(i,j)$ pour l'itération considérée et la première colonne représente les coordonnées i et j desdits éléments candidats. L'élément extrait de la liste des éléments candidats lors de cette itération apparait en caractères gras dans le tableau.

| | n=1 |
|---|---|
| i,j | $T_\Sigma(i,j)$ |
| 1,1 | **180** |
| 2,1 | 177 |
| 3,1 | 150 |
| 4,1 | 145 |
| 5,1 | 144 |

| | n=2 |
|---|---|
| i,j | $T_\Sigma(i,j)$ |
| 1,2 | 171 |
| 2,1 | **177** |
| 3,1 | 150 |
| 4,1 | 145 |
| 5,1 | 144 |

| | n=3 |
|---|---|
| i,j | $T_\Sigma(i,j)$ |
| 1,2 | **171** |
| 2,2 | 168 |
| 3,1 | 150 |
| 4,1 | 145 |
| 5,1 | 144 |

| | n=4 |
|---|---|
| i,j | $T_\Sigma(i,j)$ |
| 1,3 | 163 |
| 2,2 | **168** |
| 3,1 | 150 |
| 4,1 | 145 |
| 5,1 | 144 |

| | n=5 |
|---|---|
| i,j | $T_\Sigma(i,j)$ |
| 1,3 | **163** |
| 2,3 | 160 |
| 3,1 | 150 |
| 4,1 | 145 |
| 5,1 | 144 |

| | n=6 |
|---|---|
| i,j | $T_\Sigma(i,j)$ |
| 1,4 | 150 |
| 2,3 | **160** |
| 3,1 | 150 |
| 4,1 | 145 |
| 5,1 | 144 |

| | n=7 |
|---|---|
| i,j | $T_\Sigma(i,j)$ |
| 1,4 | **150** |
| 2,4 | 147 |
| 3,1 | 150 |
| 4,1 | 145 |
| 5,1 | 144 |

| | n=8 |
|---|---|
| i,j | $T_\Sigma(i,j)$ |
| 1,5 | 149 |
| 2,4 | 147 |
| 3,1 | **150** |
| 4,1 | 145 |
| 5,1 | 144 |

| | n=9 |
|---|---|
| i,j | $T_\Sigma(i,j)$ |
| 1,5 | **149** |
| 2,4 | 147 |
| 3,2 | 141 |
| 4,1 | 145 |
| 5,1 | 144 |

| | n=10 |
|---|---|
| i,j | $T_\Sigma(i,j)$ |
| 1,6 | 139 |
| 2,4 | **147** |
| 3,2 | 141 |
| 4,1 | 145 |
| 5,1 | 144 |

| | n=11 |
|---|---|
| i,j | $T_\Sigma(i,j)$ |
| 1,6 | 139 |
| 2,5 | **146** |
| 3,2 | 141 |
| 4,1 | 145 |
| 5,1 | 144 |

| | n=12 |
|---|---|
| i,j | $T_\Sigma(i,j)$ |
| 1,6 | 139 |
| 2,6 | 136 |
| 3,2 | 141 |
| 4,1 | **145** |
| 5,1 | 144 |

Pour l'itération n=13, la liste des éléments candidats comporte les éléments: $T_\Sigma(1,6)$, $T_\Sigma(2,6)$, $T_\Sigma(3,2)$, $T_\Sigma(4,2)$ et $T_\Sigma(5,1)$. On extrait l'élément candidat ayant la valeur la plus élevée, $T_\Sigma(5,1)=144$, pour constituer le treizième élément de la liste de sortie $U_{out}$. Comme le drapeau D est à l'état "horizontal" et que i=5 $\geq \psi(n_m{}')$, le drapeau D passe à l'état "vertical" et on remplace $T_\Sigma(5,1)$ par $T_\Sigma(6,1)$ dans la liste des candidats possibles.

Pour l'itération n=14, la liste des éléments candidats comporte les éléments: $T_\Sigma(1,6)$, $T_\Sigma(2,6)$, $T_\Sigma(3,2)$, $T_\Sigma(4,2)$ et $T_\Sigma(6,1)$. On extrait l'élément candidat ayant la valeur la plus élevée, $T_\Sigma(3,2)=141$, pour constituer le quatorzième élément de la liste de sortie $U_{out}$. Comme le drapeau D est à l'état "vertical" et que i=3<p, le drapeau D reste à l'état "vertical" et on remplace $T_\Sigma(3,2)$ par $T_\Sigma(4,2)$ dans la liste des candidats possibles.

Pour l'itération n=15, la liste des éléments candidats comporte les éléments: $T_\Sigma(1,6)$, $T_\Sigma(2,6)$, $T_\Sigma(4,2)$, $T_\Sigma(4,2)$ et $T_\Sigma(6,1)$. On extrait l'élément candidat ayant la valeur la plus élevée, à savoir $T_\Sigma(4,2)=136$ ou $T_\Sigma(2,6)=136$, pour constituer le dernier élément de la liste de sortie $U_{out}$.

Ces trois itérations (n=13, n=14 et n=15) sont illustrées par les trois tableaux suivants:

|  | n=13 |  | n=14 |  | n=15 |
|---|---|---|---|---|---|
| i,j | $T_\Sigma(i,j)$ | i,j | $T_\Sigma(i,j)$ | i,j | $T_\Sigma(i,j)$ |
| 1,6 | 139 | 1,6 | 139 | 1,6 | 139 |
| 2,6 | 136 | 2,6 | 136 | 2,6 | 136 |
| 3,2 | 141 | 3,2 | **141** | 4,2 | **136** |
| 4,2 | 136 | 4,2 | 136 | 4,2 | 136 |
| 5,1 | **144** | 6,1 | 120 | 6,1 | 120 |

A noter que la liste des candidats possibles obtenue à l'issue de l'étape n=14 comporte deux fois l'élément candidat $T_\Sigma$ (4, 2), ce qui revient à réduire la taille de cette liste. Pour éviter une telle situation, on vérifie avantageusement si l'élément candidat à introduire dans la liste de candidats possibles n'appartient pas déjà à cette liste. Si tel est le cas, l'élément introduit dans la liste est alors celui correspondant au cas où l'état du drapeau D serait l'autre état. L'état du drapeau D reste toutefois inchangé pour les itérations suivantes. Dans le cas présent (itération n=14), on remplace donc $T_\Sigma$ (3, 2) par $T_\Sigma$ (4, 2) dans la liste des candidats possibles et le drapeau D reste à l'état "vertical". On obtient la liste suivante pour l'itération n=15 et on extrait soit l'élément $T_\Sigma$ (4, 2) = 136 ou $T_\Sigma$ (2, 6) = 136 pour former le dernier élément de la liste de sortie $U_{out}$.

|  | n=15 |
|---|---|
| i, j | $T_\Sigma$ (i, j) |
| 1, 6 | 139 |
| 2, 6 | 136 |
| 3, 3 | 133 |
| 4, 2 | **136** |
| 6,1 | 120 |

On obtient au final la liste de sortie suivante $U_{out}$ = {180, 177, 171, 168, 163, 160, 150, 150, 149, 147, 146, 145, 144, 141, 136} identique à celle obtenue avec le procédé de l'art antérieur mais avec un nombre réduit d'opérations.

Selon l'invention, le noeud de parité élémentaire effectue $\psi(n_m')$ additions et $\psi(n_m')$ comparaisons pour la première itération (génération du premier élément de la liste $U_{out}$) et effectue, pour chacune des itérations suivantes (génération des $n_m'$ - 1 derniers éléments de la liste $U_{out}$), 1 addition et $\psi(n_m')$ comparaisons. La génération de la liste $U_{out}$ complète ($n_m'$ éléments) requiert donc l'exécution de $\psi(n_m')+n_m'$-1 additions et $\psi(n_m')*n_m'$ comparaisons. En variante, on peut sélectionner $p<\psi(n_m')$ pour simplifier les calculs mais cela induit une perte d'optimisation en termes de performance. Il s'agit alors de trouver un bon compromis entre complexité et performance.

Dans le mode de réalisation décrit précédemment, la sélection de l'élément candidat qui doit remplacer l'élément candidat $T_\Sigma$ (i, j) extrait de la liste des candidats est effectuée en fonction du drapeau D et des ordres i et j. En variante, on propose d'effectuer cette sélection uniquement en fonction des ordres i et j.

Selon ce mode de réalisation en variante, on définit une règle de remplacement basée uniquement sur les ordres i et j de l'élément candidat extrait. Par exemple, si on considère une première liste de candidats possibles $T_\Sigma$ (1, 1), $T_\Sigma$ (2, 1), $T_\Sigma$ (3, 1) et $T_\Sigma$ (4, 1), la règle de remplacement est par exemple définie de la manière suivante:

- $\forall j \in [1, n_m]$, si i≤2, alors l'élément candidat $T_\Sigma$ (i, j) est remplacé par l'élément candidat $T_\Sigma$ (i, j+1)
- $\forall j \in [1, n_m]$, si i≥4, alors l'élément candidat $T_\Sigma$ (i, j) est remplacé par l'élément candidat $T_\Sigma$ (i+1, j)
- si i=3 et j=1, alors l'élément candidat $T_\Sigma$ (i, j) est remplacé par l'élément candidat $T_\Sigma$ (i, j+1)
- si i≥3 et j=2, alors l'élément candidat $T_\Sigma$ (i, j) est remplacé par l'élément candidat $T_\Sigma$ (i+1, j)

En termes de complexité, ce mode de réalisation en variante requiert le même nombre d'opérations que le premier mode de réalisation pour p=4.

Par ailleurs, chaque élément des listes $U_1$ et $U_2$ représentant une valeur de LLR associée à un symbole dans le corps de Galois GF(q), chaque élément de la liste des éléments candidats est aussi associé à un symbole dans le corps de Galois GF(q). Or, il arrive que l'élément candidat ayant la valeur la plus élevée soit associé à un symbole qui est également associé à un élément candidat déjà contenu dans la liste de sortie $U_{out}$. Un même symbole de GF(q) peut en effet être associé à deux éléments candidats $T_\Sigma$ (i+1, j) différents. Aussi, avantageusement, le noeud de parité élémentaire effectue, après détermination de l'élément candidat ayant la valeur la plus élevée, une étape de détermination du symbole associé audit élément candidat déterminé. L'élément candidat déterminé est alors introduit dans la liste de sortie $U_{out}$ si et seulement si le symbole qui lui est associé n'est pas associé à un élément candidat déjà présent dans la liste de sortie.

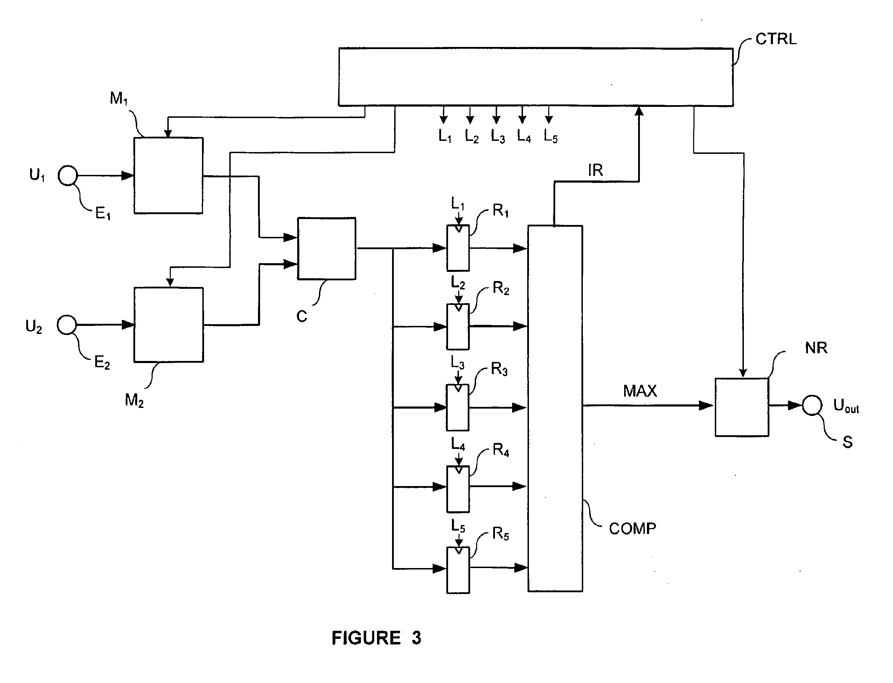

La structure d'un noeud de parité élémentaire apte à mettre en oeuvre le procédé de l'invention est représentée à la figure 3. Ledit noeud comprend deux entrées $E_1$ et $E_2$ pour recevoir respectivement les listes d'entrée $U_1$ et $U_2$ à traiter, chacune de ces listes comportant $n_m$ éléments triés dans l'ordre décroissant, et une sortie S pour délivrer la liste de sortie $U_{out}$ générée par le noeud de parité élémentaire, la liste de sortie comprenant $n_m'$ éléments triés dans l'ordre décroissant. Le noeud de parité élémentaire comprend également

- des moyens de stockage, tels que des mémoires M1 et M2, pour sauvegarder les listes d'entrée $U_1$ et $U_2$ reçues aux entrées E1 et E2,
- un circuit de calcul C pour additionner des éléments de la liste d'entrée $U_1$ avec des éléments de la liste d'entrée $U_2$ pour générer les éléments candidats,
- p=$\psi(n_m')$ registres $R_k$, k $\in$ [1, p] pour stocker les éléments candidats calculés par le circuit de calcul,
- un circuit de comparaison COMP pour déterminer, parmi les éléments candidats stockés dans les registres $R_k$, l'élément candidat ayant la valeur la plus élevée, et délivrer une information IR identifiant le registre $R_k$ duquel provient l'élément candidat ayant la valeur la plus élevée,
- un bloc NR, dit de suppression de redondance, pour supprimer les éléments candidats délivrés par le circuit de comparaison qui sont associés à un symbole de GF(q) déjà associé à un élément fourni à la sortie S du noeud, et
- un circuit de commande CTRL pour recevoir l'information IR et contrôler l'ensemble des circuits du noeud, notamment les mémoires $M_1$ et $M_2$, les registres $R_i$ et le bloc de suppression de redondance NR conformément au procédé de commande de l'invention.

Dans l'exemple de la figure 3, le noeud comporte p=5 registres.

En début de procédé, le circuit de commande CTRL commande la mémoire $M_1$ pour qu'elle délivre les p premiers éléments de la liste $U_1$ et la mémoire $M_2$ pour qu'elle délivre le premier élément de la liste $U_2$. Ces éléments sont additionnés par le circuit de calcul C et les p résultats sont stockés dans les p registres $R_k$. Ces p résultats constituent la liste de candidats possibles pour le premier élément de la liste $U_{out}$. Ces p résultats sont ensuite chargés dans le circuit de comparaison COMP chargé de délivrer l'élément candidat, noté MAX, ayant la valeur la plus élevée sur la sortie S.

A noter que plusieurs structures de circuit de comparaison sont possibles pour délivrer l'élément candidat MAX. Selon une première structure, le circuit de comparaison comporte p-1 circuits élémentaires de comparaison montés en arbre, chaque circuit élémentaire comparant deux valeurs d'entrée entre elles. Selon une deuxième structure, le circuit de comparaison comprend un nombre différent de circuits élémentaires de comparaison arrangés entre eux pour former une structure de tri par insertion bien connue en soi.

Le circuit de comparaison COMP est également prévu pour fournir au circuit de commande l'information IR identifiant le registre $R_k$ duquel provient l'élément candidat MAX. L'information IR est générée à partir des signaux de commande des circuits élémentaires de comparaison.

A partir de l'information IR et d'un registre interne sauvegardant les coordonnées (i,j) des éléments candidats $T_\Sigma$ (i, j) = $U_1$ (i) + $U_2$ (j) stockés dans les registres $R_k$, le circuit de commande détermine les coordonnées (i,j) de l'élément candidat MAX délivré par le circuit de comparaison COMP. Il détermine ensuite, en fonction de l'état d'un drapeau D sauvegardé dans un registre interne et desdites coordonnées (i,j), les coordonnées (i',j') du prochain élément candidat à charger dans le circuit de comparaison. En fonction du drapeau D, (i', j') = (i+1, j) ou (i', j') = (i, j+1). Le circuit de commande CTRL commande ensuite les mémoires $M_1$ et $M_2$ pour qu'elle délivre les éléments $U_1$ (i') et $U_2$ (j') et commande le registre $R_i$ identifié dans l'information IR pour sauvegarder l'élément candidat $T_\Sigma$ (i', j') = $U_1$ (i') + $U_2$ (j'). Ainsi, seul le registre $R_i$ identifié dans l'information IR est rechargé avec un nouvel élément candidat.

L'information IR est également employée pour supprimer les éléments candidats délivrés par le circuit de comparaison COMP qui sont associés à un symbole de GF(q) déjà associé à un élément fourni à la sortie S du noeud. Les coordonnées (i,j) déterminées à partir de l'information IR sont utilisées par le circuit de commande CTRL pour déterminer le symbole associé à l'élément candidat $T_\Sigma$ (i, j) présent à la sortie du circuit de comparaison. Cette information de symbole, notée IS, est par exemple enregistrée dans un registre spécifique, dit de symboles, du circuit de commande CTRL. Avant chaque enregistrement, l'information de symbole IS est toutefois comparée à celles déjà enregistrées dans le registre. Si l'information de symbole est déjà présente dans le registre, cela signifie que la liste de sortie $U_{out}$ comporte déjà un élément associé au symbole contenu dans l'information IS. Dans ce cas, le circuit CTRL commande le bloc NR pour qu'il ne fournisse pas l'élément candidat $T_\Sigma$ (i, j) à la sortie S. Si l'information de symbole IS n'est pas déjà présente dans le registre de symboles, elle y est enregistrée et le bloc NR fournit l'élément candidat $T_\Sigma$ (i, j) à la sortie S.

Comme on peut le voir sur la figure 3, ce noeud de parité élémentaire comporte un nombre réduit ($p=\psi(n_m')$) de registres. Il permet donc d'utiliser un nombre réduit de circuits élémentaires de comparaisons dans le circuit de comparaison COMP. Il permet également d'obtenir des temps de latence plus faibles que les noeuds de parité élémentaires classiques.

Pour accélérer le débit du noeud de parité élémentaire, il est également possible de générer la liste de sortie $U_{out}$ en traitant les listes d'entrée par blocs de plusieurs éléments. Les moyens du noeud de parité élémentaire sont alors dupliqués pour permettre un traitement parallèle des éléments des blocs.

Bien que l'invention ait été décrite en liaison avec différents modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention.

L'invention a notamment été décrite dans le cadre de listes d'entrée et de sortie comprenant des éléments appartenant à un corps de Galois GF(q) mais, d'une manière plus générale, elle est applicable à toute liste comprenant des éléments appartenant à un ensemble muni d'au moins une loi de composition interne.

Par ailleurs, l'invention a été décrite dans le cadre d'une liste de sortie comprenant des éléments qui sont les résultats d'opérations d'addition entre éléments des listes d'entrée. D'une manière plus générale, l'invention est applicable à des opérations de calcul $\varphi$ où $\varphi$ est une fonction telle que, si a≥b et c≥d, alors $\varphi(a, c) \geq \varphi(b, d)$.

D'autre part, dans les modes de réalisation décrits précédemment, la liste de candidats possibles pour chaque élément de la liste de sortie $U_{out}$ comprend $p=\psi(n_m')$ éléments candidats mais, bien entendu, p peut être choisi différemment à condition toutefois d'être inférieur à $n_m$ pour réduire le nombre de comparaisons. Il peut être inférieur à $\psi(n_m')$ (solution sous-optimale) ou supérieur à $n_m$ (solution sur-optimale).

Bien entendu, le procédé de commande de noeud élémentaire de parité décrit précédemment s'applique à tout décodeur utilisant au moins une contrainte de parité non binaire.

Enfin, l'invention a été décrite dans le cadre d'un noeud de parité élémentaire destiné à générer, à partir de deux listes d'entrée triées dans l'ordre décroissant, une liste de sortie triée dans l'ordre décroissant comportant les plus grandes valeurs des deux listes d'entrée. L'invention est aussi applicable à un noeud de parité élémentaire destiné à générer, à partir de deux listes d'entrée triées dans l'ordre croissant, une liste de sortie triée dans l'ordre croissant comportant les plus petites valeurs des deux listes d'entrée en sélectionnant à chaque itération du procédé la plus petite valeur de la liste des candidats. Ce noeud de parité élémentaire peut par exemple être utilisé dans un récepteur apte à recevoir des signaux modulés selon une modulation MAQ (Modulation d'amplitude en quadrature). Le noeud est alors utilisé pour déterminer, parmi les symboles de la constellation, les symboles les plus proches du symbole reçu. Si la constellation est représentée selon un diagramme en (x,y), la première liste d'entrée représente par exemple les écarts en x au carré, triés par ordre croissant, entre le symbole reçu et les symboles de la constellation et la deuxième liste d'entrée représente les écarts en y au carré, triés par ordre croissant, entre le symbole reçu et les symboles de la constellation. La fonction $\varphi$ est alors $\varphi (x, y) = x+y$ pour obtenir en sortie la liste des $n_m$ symboles ou points de la constellation les plus proches du symbole reçu, ladite liste étant triée par distance quadratique croissante.

## Revendications

**1.** Procédé de commande d'un noeud de parité élémentaire d'un décodeur de codes LDPC non binaires ou d'un décodeur de codes utilisant au moins une contrainte de parité non binaire, ledit noeud de parité élémentaire recevant des première et seconde listes ($U_1$, $U_2$), dites première et seconde listes d'entrée, de $n_m$ éléments triés dans un ordre défini parmi un ordre décroissant et un ordre croissant, $n_m$ étant supérieur à 1, et délivrant une liste ($U_{out}$), dite liste de sortie, de $n_m'$ éléments triés dans ledit ordre défini, $n_m'$ étant supérieur à 1, chaque élément de la liste de sortie ($U_{out}$) étant le résultat d'une opération de calcul $\varphi$ entre un élément de la première liste d'entrée ($U_1$) et un élément de la deuxième liste d'entrée ($U_2$), ladite opération de calcul $\varphi$ étant telle que si a≥b et c≥d alors $\varphi(a, c) \geq \varphi(b, d)$, ledit procédé étant **caractérisé en ce qu'**il comprend les étapes suivantes :

a) sélectionner les p premiers éléments de la première liste d'entrée ($U_1$) et le premier élément de la deuxième liste d'entrée ($U_2$), p étant un nombre prédéterminé inférieur à $n_m$,
b) effectuer des opérations de calcul $\varphi$ entre les éléments sélectionnés de la première liste d'entrée ($U_1$) et l'élément sélectionné de la seconde liste d'entrée ($U_2$) de manière à générer une liste de p éléments candidats pour la liste de sortie,
c) déterminer, parmi les p éléments candidats, l'élément candidat ayant la valeur la plus élevée si l'ordre défini est l'ordre décroissant ou l'élément candidat ayant la valeur la plus faible si l'ordre défini est l'ordre croissant, et l'introduire dans la liste de sortie ($U_{out}$), l'élément candidat introduit dans la liste de sortie étant le résultat de l'opération de calcul $\varphi$ entre un élément d'ordre i de la première liste d'entrée et un élément d'ordre j de la deuxième liste d'entrée, i et j étant compris entre 1 et $n_m$,

d) sélectionner, selon un critère prédéterminé, l'élément d'ordre i de la première liste d'entrée et l'élément d'ordre j+1 de la deuxième liste d'entrée ou l'élément d'ordre i+1 de la première liste d'entrée et l'élément d'ordre j de la deuxième liste d'entrée,

e) effectuer une opération de calcul $\varphi$ entre les éléments sélectionnés de manière à générer un nouvel élément candidat, et remplacer, dans la liste des p éléments candidats, le dernier élément candidat introduit dans la liste de sortie par ledit nouvel élément candidat,

f) déterminer, parmi les p éléments candidats, l'élément candidat ayant la valeur la plus élevée si l'ordre défini est l'ordre décroissant ou l'élément candidat ayant la valeur la plus faible si l'ordre défini est l'ordre croissant, et l'introduire dans la liste de sortie ($U_{out}$) dans l'ordre de détermination, l'élément candidat introduit dans la liste de sortie étant le résultat de l'opération de calcul entre un élément d'ordre i de la première liste d'entrée et un élément d'ordre j de la deuxième liste d'entrée, et

g) réitérer les étapes d) à f) jusqu'à ce que la liste de sortie comporte $n_m$' éléments.

2. Procédé selon la revendication 1, **caractérisé en ce que** le nombre p est égal à $\left\lceil \dfrac{-1 + \sqrt{-7 + 8n_m'}}{2} \right\rceil$ où

$\lceil x \rceil$ représente le plus petit nombre entier supérieur ou égal au nombre réel x.

3. Procédé selon la revendication 1 ou 2, **caractérisé en ce que**, selon un premier critère prédéterminé, la sélection effectuée à l'étape d) dépend de l'ordre i de l'élément de la première liste d'entrée ($U_1$) et/ou de l'ordre j de l'élément de la deuxième liste d'entrée ($U_2$) associé à l'élément candidat introduit dans la liste de sortie.

4. Procédé selon la revendication 1 ou 2, **caractérisé en ce que**, selon un deuxième critère prédéterminé, la sélection effectuée à l'étape d) dépend de l'ordre i de l'élément de la première liste d'entrée ($U_1$) et de l'ordre j de l'élément de la deuxième liste d'entrée ($U_2$) associé à l'élément candidat introduit dans la liste de sortie et d'un drapeau représentatif de la sélection effectuée à l'étape d) précédente.

5. Procédé selon l'une quelconque des revendications précédentes, **caractérisé en ce que** les éléments des listes d'entrée et de la liste de sortie sont des logarithmes de rapport de vraisemblance.

6. Procédé selon la revendication 5, **caractérisé en ce que** l'opération de calcul est une addition.

7. Procédé selon l'une quelconque des revendications précédentes, **caractérisé en ce que**, chacun des éléments desdites première et seconde listes d'entrée ($U_1$, $U_2$) étant associé à un symbole dans un corps de Galois, l'étape f) comprend en outre, après détermination de l'élément candidat ayant la valeur la plus faible ou la plus élevée, une étape de détermination du symbole associé audit élément candidat déterminé, ledit élément candidat déterminé étant introduit dans la liste de sortie si et seulement si le symbole associé audit élément candidat déterminé n'est pas associé à un élément candidat présent dans la liste de sortie.

8. Noeud de parité élémentaire, comprenant:

- des première et seconde entrées pour recevoir des première et seconde listes ($U_1$, $U_2$), dites première et seconde listes d'entrée, de $n_m$ éléments triés dans un ordre défini parmi un ordre décroissant et un ordre croissant, $n_m$ étant supérieur à 1,

- une sortie pour délivrer une liste ($U_{out}$), dite liste de sortie, de $n_m$' éléments triés dans l'ordre défini, $n_m$' étant supérieur ou égal à 1, chaque élément de la liste de sortie étant le résultat d'une opération de calcul $\varphi$ entre un élément de la première liste d'entrée et un élément de la deuxième liste d'entrée, ladite opération de calcul $\varphi$ étant telle que si a≥b et c≥d alors $\varphi(a, c) \geq \varphi(b, d)$,

- des premiers moyens de stockage pour stocker les éléments desdites première et secondes listes d'entrée ($U_1$, $U_2$),

- un circuit de calcul pour effectuer des opérations de calcul $\varphi$ entre des éléments de la première liste d'entrée et des éléments de la seconde liste d'entrée stockés dans lesdits premiers moyens de stockage de manière à générer, à chaque opération, un élément candidat,

- des seconds moyens de stockage pour stocker les éléments candidats calculés par ledit circuit de calcul,

- un circuit de comparaison pour déterminer, parmi les éléments candidats stockés dans les seconds moyens de stockage, l'élément candidat ayant la valeur la plus élevée si l'ordre défini est l'ordre décroissant ou l'élément candidat ayant la valeur la plus faible si l'ordre défini est l'ordre croissant, et fournir ledit élément candidat déterminé à ladite sortie, ledit élément candidat fourni à la sortie étant le résultat de l'opération de calcul φ entre un élément d'ordre i de la première liste d'entrée et un élément d'ordre j de la deuxième liste d'entrée, i et j étant compris entre 1 et $n_m$, et

- un circuit de commande pour contrôler la sélection des éléments stockés dans lesdits premiers moyens de stockage fournis au circuit de calcul et le stockage des éléments candidats calculés dans les seconds moyens de stockage,

**caractérisé en ce que** les seconds moyens de stockage comprennent p registres pour stocker p éléments candidats, p étant un nombre prédéterminé inférieur à $n_m$,

**en ce que** ledit circuit de comparaison est apte à fournir au circuit de commande une information représentative des ordres i et j associés audit élément candidat fourni à la sortie,

et **en ce que** le circuit de commande est apte à commander lesdits premiers moyens de stockage et lesdits seconds moyens de stockage pour la mise en oeuvre du procédé de commande selon l'une quelconque des revendications 1 à 7.

**Claims**

1. A method for controlling an elementary parity node of a decoder for decoding non-binary LDPC codes or a code decoder using at least one non-binary parity constraint, said elementary parity node receiving first and second lists ($U_1$, $U_2$), referred to as first and second input lists, having $n_m$ elements sorted in an order defined among a descending order and an ascending order, $n_m$ being greater than 1, and delivering a list ($U_{out}$), referred to as the output list, having $n_m$' elements sorted in said defined order, $n_m$' being greater than 1, each element of the output list ($U_{out}$), being the result of a computing operation φ between an element of the first input list ($U_1$) and an element of the second input list ($U_2$), said computing operation φ being such that, if a≥b and c≥d, then φ(a, c) ≥ φ(b, d), said method being **characterized in that** it includes the following steps:

a) selecting the p first elements of the first input list ($U_1$) and the first element of the second input list ($U_2$), p being a predetermined number less than $n_m$,

b) carrying out computing operations φ between the elements selected from the first input list ($U_1$) and the element selected from the second input ($U_2$) list so as to generate a list of p candidate elements for the output list,

c) determining, from amongst the p candidate elements, the candidate element having the highest value if the defined order is the descending order, or the candidate element having the lowest value if the defined order is the ascending order, and inserting it into the output list ($U_{out}$), the candidate element inserted into the output list being the result of the computing operation φ between an element of order i of the first input list and an element of order j of the second input list, i and j being between 1 and $n_m$,

d) selecting, according to a predetermined criterion, the element of order i of the first input list and the element of order j+1 of the second input list or the element of order i+1 of the first input list and the element of order j of the second input list,

e) carrying out a computing operation φ between the elements selected in the preceding step so as to generate a new candidate element, and replacing, in the list of p candidate elements, the last candidate element inserted into the output list by said new candidate element,

f) determining, from amongst the p candidate elements, the candidate element having the highest value if the defined order is the descending order, or the candidate element having the lowest value if the defined order is the ascending order, and inserting it into the output list ($U_{out}$) in the order of determination, the candidate element inserted into the output list being the result of the computing operation between an element of order i of the first input list and an element of order j of the second input list, and

g) repeating steps d) to f) until the output list comprises $n_m$' elements.

2. The method according to claim 1, **characterised in that** the number p is equal to $\left\lceil \dfrac{-1 + \sqrt{-7 + 8n_m'}}{2} \right\rceil$

wherein $\lceil x \rceil$ represents the smallest integer greater than or equal to the real number x.

3. The method according to claim 1 or 2, **characterised in that**, according to a first predetermined criterion, the selection made in step d) depends on the order i of the element of the first input list ($U_1$) and/or the order j of the element of the second input list (U2) associated with the candidate element inserted into the output list.

4. The method according to claim 1 or 2, **characterised in that**, according to a second predetermined criterion, the selection made in step d) depends on the order i of the element of the first input list ($U_1$) and the order j of the element of the second input list ($U_2$) associated with the candidate element inserted into the output list and on a flag representative of the selection made in the preceding step d).

5. The method according to any of the preceding claims, **characterised in that** the elements of the input list and the output list are log likelihood ratios.

6. The method according to claim 5, **characterised in that** the computing operation is an addition operation.

7. The method according to any of the preceding claims, **characterised in that**, each of the elements of said first and second input lists ($U_1$, $U_2$) being associated with a symbol in the Galois field, the step f) further includes, after determining the candidate having the lowest or highest value, a step for determining the symbol associated with said determined candidate element, said determined candidate element being inserted into the output list if and only if the symbol associated with said determined candidate element is not associated with a candidate element present in the output list.

8. An elementary parity node, including:

- first and second inputs for receiving first and second lists, said first and second input lists ($U_1$, $U_2$), having $n_m$ elements sorted in an order defined among a descending order and an ascending order, $n_m$ being greater than 1,
- an output for delivering a list ($U_{out}$), referred to as an output list, having $n_m'$ elements sorted in the defined order, $n_m'$ being greater than or equal to 1, each element of the output list being the result of a computing operation $\varphi$ between an element of the first input list and an element of the second input list, said computing operation $\varphi$ being such that, if a≥b and c≥d then $\varphi(a, c) \geq \varphi(b, d)$,
- first storage means for storing the elements of said first and second input lists ($U_1$, $U_2$),
- a computing circuit for carrying out computing operations $\varphi$ between elements of the first input list and elements of the second input list, which are stored in said first storage means, so as to generate a candidate element upon each operation,
- second storage means for storing the candidate elements computed by said computing means,
- a comparison circuit for determining, from amongst the candidate elements stored in the second storage means, the candidate element having the highest value if the defined order is the descending order, or the candidate element having the lowest value if the defined order is the ascending order, and providing said determined candidate element to the output, the candidate element provided to the output being the result of the computing operation $\varphi$ between an element of order i of the first input list and an element of order j of the second input list, i and j being between 1 and $n_m$, and
- a control circuit for controlling the selection of the elements stored in said first storage means, to be provided to the computing circuit and storage of the computed candidate elements in the second storage means, **characterised in that** the second storage means include p registers for storing p candidate elements, p being a predetermined number lower than $n_m$,

**in that** said comparison circuit is capable of providing information to the control circuit, which is representative of the orders i and j associated with said candidate element provided to the output,
and **in that** the control circuit is capable of controlling said first storage means and said second storage means for implementing the control method according to any of claims 1 to 7.

**Patentansprüche**

1. Vorfahren zur Steuerung eines elementaren Paritätsknotens eines Decodierers nicht-binärer LDPC-Codes oder eines Decodierers von Knoten, die mindestens eine nicht-binäre Paritätsbedingung verwenden, wobei der elementare Paritätsknoten erste und zweite Listen ($U_1$, $U_2$), erste und zweite Eingangsliste genannt, von $n_m$ Elementen empfängt, die in einer zwischen einer absteigenden und einer aufsteigenden Ordnung definierten Ordnung sortiert sind, wobei $n_m$ größer ist als 1, und eine Liste ($U_{out}$), Ausgangsliste genannt, von $n_m'$ in der definierten Ordnung sortierten Elementen liefert, wobei $n_m'$ größer ist als 1, wobei jedes Element der Ausgangsliste ($U_{out}$) das Ergebnis einer Rechenoperation $\varphi$ zwischen einem Element der ersten Eingangsliste ($U_1$) und einem Element der zweiten Eingangsliste ($U_2$) ist, wobei die Rechenoperation $\varphi$ so ist, dass, wenn a ≥ b und c ≥ d ist, gilt $\varphi(a, c) \geq \varphi(b, d)$, wobei das Verfahren **dadurch gekennzeichnet ist, dass** es die folgenden Schritt enthält:

a) Auswahl der p ersten Elemente der ersten Eingangsliste ($U_1$) und des ersten Elements der zweiten Eingangsliste ($U_2$), wobei p eine vorbestimmte Zahl kleiner als $n_m$ ist,

b) Durchführen von Rechenoperationen $\varphi$ zwischen den ausgewählten Elementen der ersten Eingangsliste ($U_1$) und dem ausgewählten Element der zweiten Eingangsliste ($U_2$), um eine Liste von p Kandidat-Elementen für die Ausgangsliste zu erzeugen,

c) Ermitteln, unter den p Kandidat-Elementen, des Kandidat-Elements mit dem höchsten Wert, wenn die definierte Ordnung die absteigende Ordnung ist, oder des Kandidat-Elements mit dem geringsten Wert, wenn die definierte Ordnung die aufsteigende Ordnung ist, und sein Einfügen in die Ausgangsliste ($U_{out}$), wobei das in die Ausgangsliste eingefügte Kandidat-Element das Ergebnis der Rechenoperation $\varphi$ zwischen einem Element der Ordnung i der ersten Eingangsliste und einem Element der Ordnung j der zweiten Eingangsliste ist, wobei i und j zwischen 1 und $n_m$ liegen,

d) Auswahl, gemäß einem vorbestimmten Kriterium, des Elements der Ordnung i der ersten Eingangsliste und des Elements der Ordnung j+1 der zweiten Eingangsliste oder des Elements der Ordnung i+1 der ersten Eingangsliste und des Elements der Ordnung j der zweiten Eingangsliste,

e) Ausführen einer Rechenoperation $\varphi$ zwischen den ausgewählten Elementen, um ein neues Kandidat-Element zu erzeugen, und Ersetzen, in der Liste der p Kandidat-Elemente, des letzten in die Ausgangsliste eingeführten Kandidat-Elements durch das neue Kandidat-Element,

f) Ermitteln, unter den p Kandidat-Elementen, des Kandidat-Elements mit dem höchsten Wert, wenn die definierte Ordnung die absteigende Ordnung ist, oder des Kandidat-Elements mit dem geringsten Wert, wenn die definierte Ordnung die aufsteigende Ordnung ist, und sein Einführen in die Ausgangsliste ($U_{out}$) in der Ermittlungsordnung, wobei das in die Ausgangsliste eingeführte Kandidat-Element das Ergebnis der Rechenoperation zwischen einem Element der Ordnung i der ersten Eingangsliste und einem Element der Ordnung j der zweiten Eingangsliste ist, und

g) Wiederholen der Schritte d) bis f), bis die Ausgangsliste $n_m'$ Elemente aufw... ...

2. Verfahren nach Anspruch 1, **dadurch gekennzeichnet, dass** die Anzahl p gleich $\left\lceil \dfrac{-1 + \sqrt{-7 + 8n_m'}}{2} \right\rceil$ ist,

wobei $\lceil x \rceil$ die kleinste ganze Zahl größer als die oder gleich der reellen Zahl x ist.

3. Vorfahren nach Anspruch 1 oder 2, **dadurch gekennzeichnet, dass** gemäß einem ersten vorbestimmten Kriterium die im Schritt d) durchgeführte Auswahl von der Ordnung i des Elements der ersten Eingangsliste ($U_1$) und/oder von der Ordnung j des Elements der zweiten Eingangsliste ($U_2$) abhängt, die dem in die Ausgangsliste eingeführten Kandidat-Element zugeordnet ist.

4. Verfahren nach Anspruch 1 oder 2, **dadurch gekennzeichnet, dass** gemäß einem zweiten vorbestimmten Kriterium die im Schritt d) durchgeführte Auswahl von der Ordnung i des Elements der ersten Eingangsliste ($U_1$) und von der Ordnung j des Elements der zweiten Eingangsliste ($U_2$), die dem in die Ausgangsliste eingeführten Kandidat-Element zugeordnet ist, und von einem Flag abhängt, das für die im vorhergehenden Schritt d) ausgeführte Auswahl repräsentativ ist.

5. Verfahren nach einem der vorhergehenden Ansprüche, **dadurch gekennzeichnet, dass** die Elemente der Eingangsliste und der Ausgangsliste Likelihood-Verhältnis-Logarithmen sind.

6. Verfahren nach Anspruch 5, **dadurch gekennzeichnet, dass** die Rechenoperation eine Addition ist.

7. Vorfahren nach einem der vorhergehenden Ansprüche, **dadurch gekennzeichnet, dass**, da jedes der Elemente der ersten und zweiten Eingangsliste ($U_1$, $U_2$) einem Symbol in einem Galois-Körper zugeordnet ist, der Schritt f) außerdem nach der Ermittlung des Kandidat-Elements mit dem geringsten oder dem höchsten Wert einen Schritt der Ermittlung des dem ermittelten Kandidat-Element zugeordneten Symbols enthält, wobei das ermittelte Kandidat-Element in die Ausgangsliste eingeführt wird, wenn und nur wenn das dem ermittelten Kandidat-Element zugeordnete Symbol keinem in der Ausgangsliste vorhandenen Kandidat-Element zugeordnet ist.

8. Elementarer Paritätsknoten, der enthält:

- erste und zweite Eingänge, um erste und zweite Listen ($U_1$, $U_2$), erste und zweite Eingangsliste genannt, von $n_m$ Elementen zu empfangen, die in einer zwischen einer absteigenden Ordnung und einer aufsteigenden Ordnung definierten Ordnung sortiert sind, wobei $n_m$ größer ist als 1,

- einen Ausgang, um eine Liste ($U_{out}$), Ausgangsliste genannt, von $n_m$' in der definierten Ordnung sortierten Elementen zu liefern, wobei $n_m$' größer als oder gleich 1 ist, wobei jedes Element der Ausgangsliste das Ergebnis einer Rechenoperation $\varphi$ zwischen einem Element der ersten Eingangsliste und einem Element der zweiten Eingangsliste ist, wobei die Rechenoperation $\varphi$ so ist, dass, wenn $a \geq b$ und $c \geq d$ ist, gilt $\varphi(a, c) \geq \varphi(b, d)$,

- erste Speichereinrichtungen, um die Elemente der ersten und zweiten Eingangsliste ($U_1$, $U_2$) zu speichern,

- einen Rechenkreis, um Rechenoperationen $\varphi$ zwischen Elementen der ersten Eingangsliste und Elementen der zweiten Eingangsliste, die in den ersten Speichereinrichtungen gespeichert sind, durchzuführen, um bei jeder Operation ein Kandidat-Element zu erzeugen,

- zweite Speichereinrichtungen, um die vom Rechenkreis berechneten Kandidat-Elemente zu speichern,

- einen Vergleichskreis, um unter den in den zweiten Speichereinrichtungen gespeicherten Kandidat-Elementen das Kandidat-Element mit dem höchsten Wert zu ermitteln, wenn die definierte Ordnung die absteigende Ordnung ist, oder das Kandidat-Element mit dem geringsten Wert zu ermitteln, wenn die definierte Ordnung die aufsteigende Ordnung ist, und das ermittelte Kandidat-Element an den Ausgang zu liefern, wobei das an den Ausgang gelieferte Kandidat-Element das Ergebnis der Rechenoperation $\varphi$ zwischen einem Element der Ordnung i der ersten Eingangsliste und einem Element der Ordnung j der zweiten Eingangsliste ist, wobei i und j zwischen 1 und $n_m$ liegen; und

- einen Steuerkreis zum Regeln der Auswahl der in den ersten Speichereinrichtungen gespeicherten Elemente, die an den Rechenkreis geliefert werden, und der Speicherung der berechneten Kandidat-Elemente in den zweiten Speichereinrichtungen,

**dadurch gekennzeichnet, dass** die zweiten Speichereinrichtungen p Register enthalten, um p Kandidat-Elemente zu speichern, wobei p eine vorbestimmte Zahl kleiner als $n_m$ ist,

dass der Vergleichskreis an den Steuerkreis eine Information liefern kann, die für die Ordnungen i und j repräsentativ ist, die dem am Ausgang gelieferten Kandidat-Element zugeordnet sind,

und dass der Steuerkreis die ersten Speichereinrichtungen und die zweiten Speichereinrichtungen zur Anwendung des Steuerverfahrens nach einem der Ansprüche 1 bis 7 steuern kann.

$U_0$    $U_1$    $U_2$    $U_3$          $V_0$    $V_1$    $V_2$    $V_3$

P          P

FIG.1

$U_1$   $U_2$

$U_{out}$

FIG.2

FIGURE 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **D.DECLERCQ ; M.FOSSORIER.** Decoding Algorithms for Nonbinary LDPC Codes Over GF(q. *Communications IEEE Transactions,* Avril 2007, vol. 55 (4), 633-643

- **A.VOICILA ; D.DECLERCQ ; M.FOSSORIER ; F.VERDIER.** Algorithmes simplifiés pour le décodage de codes LDPC non binaires. *GRETSI,* Septembre 2005
- **A.VOICILA et al.** Low-complexily, low-memory EMS algorithm for non-binary LDPC codes. *ICC 2007,* Juin 2007